(19) Europäisches Patentamt / European Patent Office / Office européen des brevets

(11) **EP 4 712 138 A1**

(12) **EUROPEAN PATENT APPLICATION**

(43) Date of publication:
**18.03.2026 Bulletin 2026/12**

(21) Application number: **24306536.4**

(22) Date of filing: **17.09.2024**

(51) International Patent Classification (IPC):
**H01L 23/367** (2006.01)    **H01L 23/13** (2006.01)
**H01L 23/373** (2006.01)    **H01L 23/14** (2006.01)
**H01L 23/538** (2006.01)    **H01L 25/07** (2006.01)

(52) Cooperative Patent Classification (CPC):
**H10W 40/22; H10W 40/255; H10W 70/611;
H10W 70/68; H10W 70/685; H10W 70/6875;
H10W 90/00**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicants:
• **Mitsubishi Electric R&D Centre Europe B.V.
1119 NS  Schiphol Rijk Amsterdam (NL)**

• **MITSUBISHI ELECTRIC CORPORATION
Chiyoda-ku
Tokyo 100-8310 (JP)**

(72) Inventor: **OUHAB, Merouane
35708 RENNES CEDEX 7 (FR)**

(74) Representative: **Plasseraud IP
104 Rue de Richelieu
CS92104
75080 Paris Cedex 02 (FR)**

(54) **SEMICONDUCTOR MODULE COMPRISING AN INTERMEDIATE SUPPORT AND A MAIN SUPPORT**

(57)    A semiconductor module comprises at least one semiconductor die (1), an intermediate support (3), a main support (4; 5) and an attachment layer portion (6) for connecting the intermediate support to the main support. The attachment layer portion has a peripheral limit (L1) designed for increasing a lifetime of the semiconductor module. Further improvements are proposed, including providing same peripheral limits (L2, L3, L4) to layer portions of the intermediate support and/or providing the main support with a step (ST) or a groove.

FIG. 7a

EP 4 712 138 A1

**Description**

The invention relates to a semiconductor module that comprises an intermediate support and a main support. It focuses in particular on the connection between both intermediate and main supports.

-- **BACKGROUND OF THE INVENTION** --

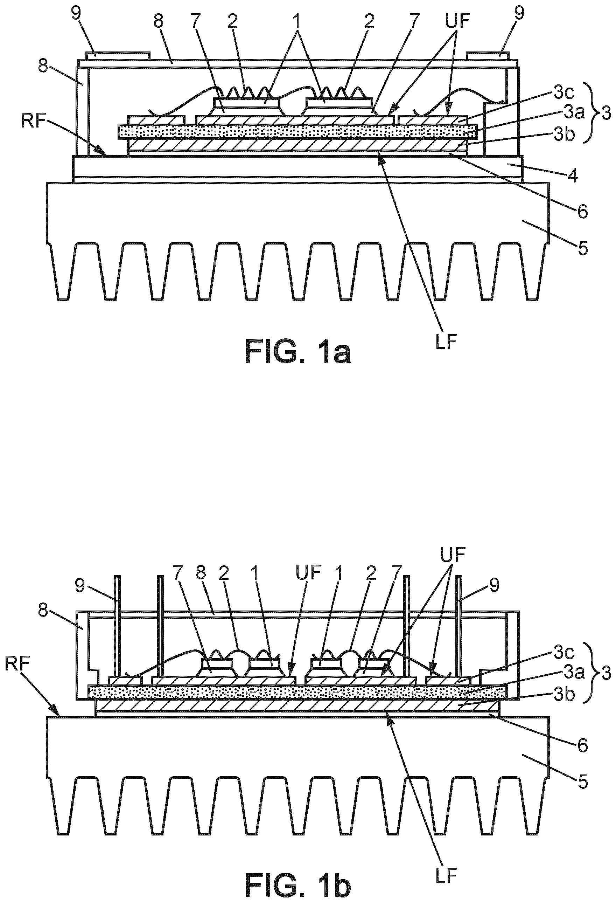

Semiconductor devices are used in many applications, in particular cases involving high electrical power they are commonly called power modules. For these latter applications, they may execute functions such as rectifier, inverter, chopper, switch-type power source, etc. They comprise electrical components such as diodes, insulated-gate bipolar transistors known as IGBTs, metal-oxide-semiconductor field effect transistors known as MOSFETs, etc, which are embodied as one or several semiconductor die(s) integrated within the same module. Power modules involve special designs and manufacturing processes, to increase reliability, to reduce losses and to better dissipate the generated heat during operation. The die(s) is (are) usually attached to an insulating substrate of the module, and this insulating substrate is attached to a heat dissipating element commonly called the heatsink, either directly or with an intermediate copper baseplate. When no baseplate is used between the insulating substate and the heat dissipating element, the insulating substrate is connected to the heat dissipating element either by soldering or by a screwing system via a thermal interface material such as a grease therebetween. In case of multiple dies within the same module, the insulating substrate is commonly attached to the dies which are placed on the upper face of this insulating substrate, and the components are electrically connected from one die to another through metal wires or ribbons or other means. With such module configurations, the insulating substrate acts as an intermediate support, and the heat dissipating element or the baseplate if any acts as a main support. Also commonly, the insulating substrate is comprised of an insulating ceramic layer which is bonded with two copper layers on both sides. This allows using the attachment process known as Direct Bonded Copper, or DBC. Possibly, the copper layer portion that is used for bonding the dies may be divided into separated sub-portions, in particular for electrical connexion purpose. Figures 1a and 1b are cross-sectional views of two semiconductor modules with (Figure 1a) and without (Figure 1b) copper baseplate. In these figures, the reference numbers denote the following module elements:

1 dies of semiconducting material, embodying electrical components

2 metal wires

3 intermediate support, also called insulating substrate in the present embodiment, including an electrically insulating bulk portion 3a, a bottom metal layer portion 3b and a top metal layer portion 3c

4 baseplate

5 heat dissipating element

6 attachment layer portion that connects the intermediate support 3 to the baseplate 4 (Figure 1a) or to the heat dissipating element (Figure 1b)

7 attachment layer portion(s) that connects the die(s) 1 to the intermediate support 3

8 casing filled with insulating gel

9 electrical terminals of the module

The attachment layer portions 6 and 7 result from known fixing processes such as soldering, sintering, etc.
Such semiconductor module heats up during operation, thus, it is important that the attachment layer portion 6 does not break after a given operation time of the module or after a given number of temperature cycles which are generated due to repetitive periods of current injection and blocking. Such attachment break is mainly due to the mismatch existing between respective Coefficient of Thermal Expansion (CTE) values of the materials involved in the above-described module assembly. Today, occurrence of such thermally induced degradation is a major limitation to the lifetime of the semiconductor modules.
Starting from this situation, one object of the present invention consists in increasing lifetime of semiconductor modules of the types just described.
More generally, the invention aims at increasing lifetime for semiconductor modules that comprise at least two superposed supports.

In particular, the invention aims at increasing lifetime for semiconductor modules which involve an insulating substrate attachment configuration.

## -- SUMMARY OF THE INVENTION --

For meeting at least one of these objects or others, an aspect of the present invention proposes a semiconductor module that comprises:

- at least one semiconductor die, which incorporates at least one electrical component;

- an intermediate support having upper and lower faces parallel to a reference plane;

- a main support having a receiving face parallel to the reference plane; and

- an attachment layer portion.

In the semiconductor module, the at least one semiconductor die is attached to the upper face of the intermediate support, and the lower face of the intermediate support is attached to the receiving face of the main support through the attachment layer portion. The attachment layer portion is attached to the intermediate support throughout the lower face of this latter and attached to the main support throughout a face of this attachment layer portion which is parallel to the reference plane. In addition, the attachment layer portion has a peripheral limit, referred to as first peripheral limit, which entirely surrounds the lower face of the intermediate support in a projection onto the reference plane. According to the invention, the first peripheral limit forms acute angles parallel to the reference plane. In the whole present description, an angle formed by a peripheral limit of a planar portion which is parallel to the reference plane is said to be acute if this angle is less than 90° (degree) when measured inside the portion. Thanks to such acute angles, the attachment layer portion can reduce the thermal stresses and withstand longer operation time in the semiconductor module. Indeed, the attachment layer portion is less prone to cracks starting from the acute angles of its peripheral limit, compared to right angles, i.e. equal to 90°, obtuse angles, i.e. of more than 90°, and rounded corners. The lifetime of the semiconductor module is increased in this way.

Preferably, all angles formed by the first peripheral limit may be less than 90°, more preferably less than 80°, even more preferably less than 75°. Crack formation starting from each angle of the first peripheral limit is thus hindered in a further extent.

Advantageously, the first peripheral limit may be comprised of several, preferably four, concave fillets connected to one another at the acute angles. Design and manufacturing of the semiconductor module are easier when four concave fillets are implemented in this way.

As a first embodiment of the invention, the acute angles may be formed by the first peripheral limit in extension parts of the attachment layer that protrude or exceed parallel to the reference plane beyond the lower face of the intermediate support, preferably beyond corners of this lower face of the intermediate support.

In second embodiments of the invention where the intermediate support comprises a bulk portion and a bottom metal layer portion which is adhered to the bulk portion and forms the lower face of the intermediate support, the bottom metal layer portion may have a peripheral limit, referred to as second peripheral limit, parallel to the reference plane which is superimposed with the first peripheral limit. Thus, the second peripheral limit forms acute angles similar to those of the first peripheral limit, and crack formation from corners of the attachment layer is hindered in a further extent. For such second invention embodiments, the bulk portion of the intermediate support may have a peripheral limit, referred to as third peripheral limit, which surrounds the second peripheral limit parallel to the reference plane. Possibly, the bulk portion may be larger than the bottom metal layer portion parallel to the reference plane. Alternatively, the third peripheral limit parallel to the reference plane may be superimposed with the second peripheral limit. Crack formation starting from each angle of the first peripheral limit is thus hindered in a further extent.

Preferably in the second embodiments of the invention when the intermediate support further comprises at least one top metal layer portion which is adhered to the bulk portion opposite the bottom metal layer portion and which forms the upper face of the intermediate support, the at least one top metal layer portion may be surrounded by the third peripheral limit parallel to the reference plane, with the bulk portion being larger than the at least one top metal layer portion parallel to the reference plane. Alternatively, the fourth peripheral limit parallel to the reference plane may be superimposed with the third peripheral limit, and preferably also superimposed with the second and first peripheral limits. Crack formation starting from each angle of the first peripheral limit is thus hindered in a further extent.

The following further improvements of the invention deal with the shape or configuration of the main support. They may be implemented separately from each of the precedingly listed first and second embodiments of the invention or in combination with any of them. Crack formation from each angle of the first peripheral limit is hindered in a further extent thanks to each of these improvements relating to the main support.

According to a first possible configuration of the main support, its receiving face may be shaped so as to exhibit a step that has a step face perpendicular to the reference plane, and this step face is superimposed with the first peripheral limit all along this latter.

According to a second possible configuration, the main support may comprise a base part and an additional layer portion which is attached to the base part, so that the receiving face of such main support is formed by the additional layer portion and limited by an edge face of this additional layer portion which is perpendicular to the reference plane and superimposed with the first peripheral limit all along this latter. In particular, the additional layer portion may be soldered, sintered or glued to the base part of the main support.

According to a third possible configuration of the main support, its receiving face may be shaped so as to exhibit a groove that has an internal sidewall perpendicular to the reference plane, and this internal sidewall of the groove may be superimposed with the first peripheral limit, with the groove extending outside the first peripheral limit.

Generally for the invention, the at least one die may incorporate at least one electrical component selected from the list consisting of a diode, a transistor, in particular of isolated-gate bipolar transistor type or of metal-oxide-semiconductor field effect transistor type, and a thyristor.

Also generally for the invention, the semiconductor module may form a circuit part selected from the list consisting of a rectifier branch, a rectifier, an inverter branch, an inverter, a chopper, a switch-type power source branch and a switch-type power source.

Again generally for the invention, the semiconductor module may comprise several semiconductor dies which are attached apart from each other to the upper face of the intermediate support. Then, the semiconductor module may further comprise electrical interconnections that connect at least one electrical component of one of the dies to at least one other electrical component of another die.

Depending on a configuration of the invention semiconductor module, the main support may comprise a baseplate, in particular a metal baseplate, or a heat dissipating element.

Also, respective attachments of the at least one semiconductor die to the intermediate support and/or of this intermediate support to the main support may be a done using a soldering or a sintering process.

These and other features of the invention will be now described with reference to the appended figures, which relate to preferred but not-limiting embodiments of the invention.

-- BRIEF DESCRIPTION OF THE DRAWINGS --

Figures 1a and 1b, already described, are respective cross-sectional views of two semiconductor modules of different configurations as known before the present invention.

Figure 2 is an example of electrical circuit that can be embodied in a semiconductor module according to the invention.

Figure 3a, 3b and 3c are respectively a cross-sectional view, an in-plane section and an in-plane projection of a first embodiment of the present invention.

Figures 4a, 4b and 4c respectively correspond to Figures 3a, 3b and 3c for another embodiment of the present invention.

Figures 5a, 5b and 5c respectively correspond to Figures 3a, 3b and 3c for still another embodiment of the present invention.

Figures 6a, 6b and 6c respectively correspond to Figures 3a, 3b and 3c for still another embodiment of the present invention.

Figures 7a, 7b and 7c respectively correspond to Figures 3a, 3b and 3c for still another embodiment of the present invention.

Figures 8a, 8b and 8c respectively correspond to Figures 3a, 3b and 3c for still another embodiment of the present invention.

Figure 9 is a perspective view that illustrates crack progress at an interface between two material portions.

For clarity sake, element sizes which appear in these figures do not correspond to actual dimensions or dimension ratios. Also, same reference signs which are indicated in different ones of these figures denote identical elements of elements with identical function.

## -- DETAILED DESCRIPTION OF THE INVENTION --

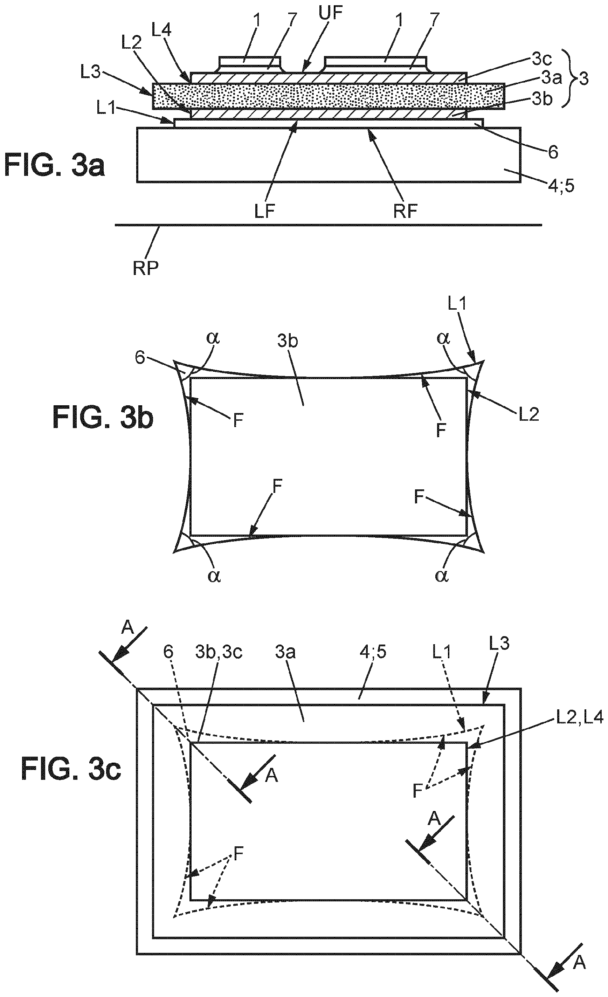

In Figures 3c-8c, A-A denotes a staggered section plane used for Figures 3a-8a. RP in Figures 3a-8a is a reference plane which is parallel to attachment faces involved in the below-described semiconductor modules, and also parallel to the section planes of Figures 3b-8b. Figures 3c-8c are views of the semiconductor modules in projection on the reference plane RP. The section plane A-A is perpendicular to the reference plane RP. Figures 3b-8b are cross-sections parallel to the reference plane RP, and Figures 3c-8c are projection views drawn in the reference plane RP for the modified layers where the acute angles are inserted. The module components are similar to those already presented with reference to Figures 1a and 1b, using same reference signs. As a reminder, the intermediate support 3 is comprised of the bulk portion 3a covered with the bottom metal layer portion 3b and the top metal layer portion 3c on both opposite sides parallel to the reference plane RP. The bulk portion 3a may be a ceramic layer portion which is electrically insulating, for example of aluminum nitride (AIN), and both metal layer portions 3b and 3c may be copper (Cu) layer portions. The main support is alternatively comprised of the baseplate 4 when module configuration of Figure 1a is used, and of the heat dissipating element 5 for module configuration of Figure 1b. The heat dissipating element 5 may have special design for enhancing heat dissipation, for example provided with fins on a side thereof opposite the intermediate support 3. RF denotes the receiving face of the main support 4, 5, which is parallel to the reference plane RP. The lower and upper faces of the intermediate support 3 are respectively denoted LF and UF, and are formed by the bottom metal later portion 3b and top metal layer portion 3c respectively. The attachment layer portions 6 and 7 may be solder or sinter layer portions, for example it can be made of tin-silver (SnAg) solder alloy or other. The attachment layer portion 6 connects the lower face LF of the intermediate support 3 to the receiving face RF of the main support 4, 5, and the attachment layer portion(s) 7 connect(s) the upper face UF of the intermediate support 3 to each die 1. In case of several dies 1 within the semiconductor module, each die may have an individual attachment layer portion 7. The intermediate support 3, namely the insulating substrate in the described embodiment, can be for example of DBC-type, standing for Direct Bonded Copper, of AMB-type, for Active metal Brazed, or of IMS-type, for Insulated Metal Substrate. Each of these substrates requires a specific manufacturing process which is known in the art.

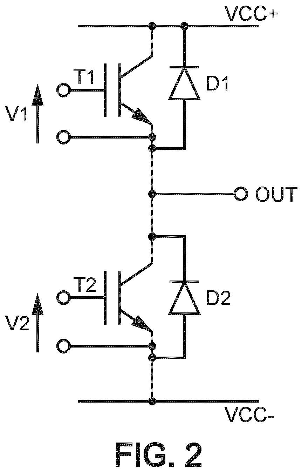

Electrical components, for example IGBTs, MOSFETs and diodes, are embedded in the die(s) 1, and electrically connected through metal wires 2 or other connecting elements known in the prior art. For exemplifying purpose with reference to Figure 2, the semiconductor modules described hereafter may each constitute an inverter leg to be connected between positive and negative DC-voltage terminals VCC+ and VCC-. T1 denotes a first IGBT with its collector connected to the VCC+ terminal and emitter connected to an inverter output terminal OUT, T2 denotes a second IGBT with its collector connected to the OUT-terminal and source connected to the VCC- terminal, D1 is a first diode connected in the reverse direction between the collector and the emitter of IGBT T1, and D2 is a second diode connected in the reverse direction between the collector and the emitter of IGBT T2. Such inverter leg is operated by applying appropriate respective control voltages V1 and V2 to the gates of transistors T1 and T2, in a manner that is well-known in power circuit applications. The OUT-terminal of such inverter leg is to be connected to a load for supplying electrical power to this latter. For example, the load may be one stator coil of an asynchronous motor having three stator coils.

In the sequel, the interface between the bottom metal layer portion 3b of the intermediate support 3 and the attachment layer portion 6 extends throughout the whole extension area of the lower face LF. It is thus possible that the attachment layer portion 6 is larger than the lower face LF parallel to the reference plane RP. In addition, the interface between the main support 4, 5 and the attachment layer portion 6 extends throughout the whole extension area of the attachment layer portion 6 parallel to the reference plane RF. Thus, the receiving face RF of the main support 4, 5 may be larger than the attachment layer portion 6 parallel to the reference plane RP. Possibly, the bulk portion 3a of the intermediate support 3 may be larger than one or both of the lower and upper metal layer portions 3b, 3c parallel to the reference plane RP. The following reference signs are used hereafter:

L1 is the peripheral limit of the attachment layer portion 6 parallel the reference plane RP, and has been called first peripheral limit in the general part of the present description;

L2 is the peripheral limit of the bottom metal layer portion 3b parallel to the reference plane RP, and has been called second peripheral limit;

L3 is the peripheral limit of the bulk portion 3a parallel to the reference plane RP, and has been called third peripheral limit; and

L4 is the peripheral limit of the top metal layer portion 3c parallel to the reference plane RP, and has been called fourth peripheral limit.

For clarity sake of Figures 3c-8c, the dies 1 and the attachment layer portions 7 have not been represented in these figures.

In all invention embodiments and as visible in the Figures 3b-3c to 8b-8c, the peripheral limit L1 forms acute angles, for example four acute angles $\alpha$ each of about 60°. Without it being necessary but in a practical manner, the peripheral limit L1 may be comprised of four concave fillets denoted F that each connect two neighbouring ones of the acute angles $\alpha$. For example, the attachment layer portion 6 may be implemented as a solder preform, possibly made of SAC305- or Sn95Sb5-alloy with thickness of about 200 $\mu$m (micrometer). According to a possible manufacturing process for implementing the invention, the solder preform may be provided with the peripheral limit L1 including the acute angles $\alpha$ through laser cutting of an initial solder foil. According to an alternative manufacturing process also possible, a specific stencil with the acute angles $\alpha$ can be used to locate the solder layer portion on the main support 4, 5 during the soldering process and achieve the targeted peripheral limit L1. Then, final attachment can be produced by implementing the usual reflow soldering thermal profile.

In the invention embodiment of Figures 3a-3c, the attachment layer portion 6 extends beyond the bottom metal layer portion 3b parallel to the reference plane RP so as to form the acute angles $\alpha$. As an example, the peripheral limit L2 may be rectangular, with sides thereof which are internal to the peripheral limit L1 and tangential with the fillets F. The section plane of Figure 3b is superimposed with the interface between the attachment layer portion 6 and the bottom metal layer portion 3b.

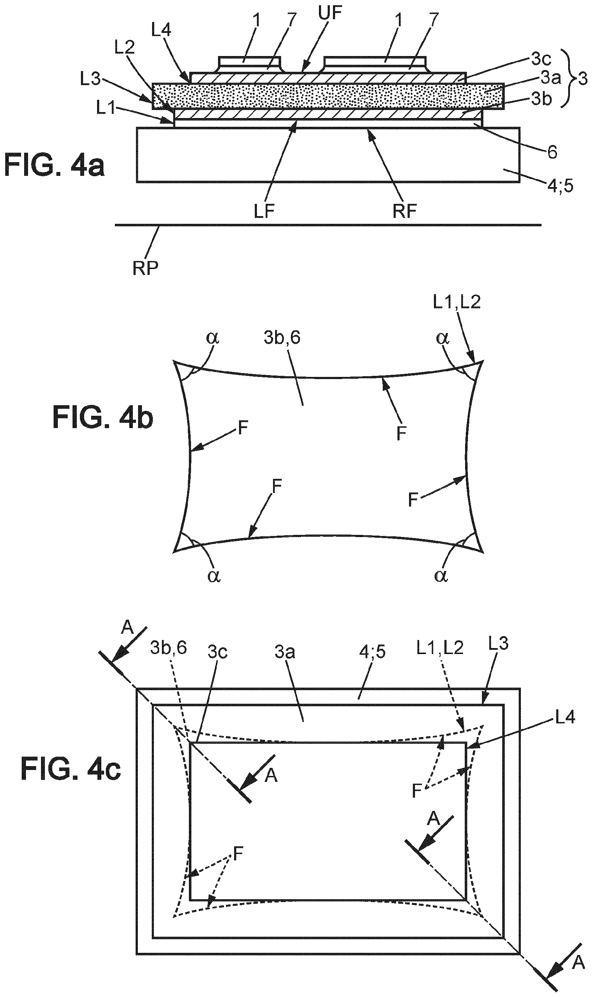

Compared with the embodiment of Figures 3a-3c, that of Figures 4a-4c is obtained by modifying the peripheral limit L2 of the bottom metal layer portion 3b so that it becomes superimposed with the peripheral limit L1 of the attachment layer portion 6. Put another way, both peripheral limits L1 and L2 are mixed in projection onto the reference plane RP, as shown in Figures 4b and 4c with the section plane of Figure 4c again superimposed with the interface between the attachment layer portion 6 and the bottom metal layer portion 3b. Thus, the attachment layer portion 6 and the bottom metal layer portion 3b have respective extension areas parallel to the reference plane RP which are identical and superimposed. In particular, the peripheral limit L2 of the bottom metal layer portion 3b exhibits the same acute angles $\alpha$ as the peripheral limit L1 of the attachment layer portion 6. For such embodiment of the invention, the DBC-type intermediate support 3 may be manufactured using a bottom copper layer portion 3b which is initially provided with desired peripheral limit L2 that includes the acute angles $\alpha$ with concave fillets.

In the embodiment of Figures 4a-4c, the bulk portion 3a extends beyond both the attachment layer portion 6 and the bottom metal layer portion 3b all around the superimposed peripheral limits L1 and L2 of these latter, parallel to the reference plane RP.

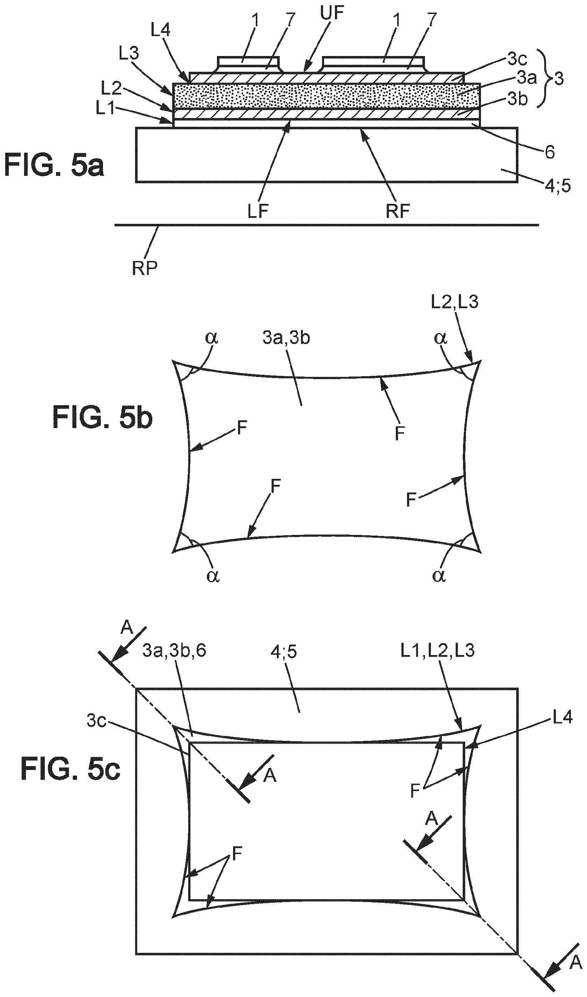

Compared with the embodiment of Figures 4a-4c, the further embodiment of Figures 5a-5c is obtained by modifying the peripheral limit L3 of the bulk portion 3a so that it becomes superimposed with both peripheral limits L1 and L2. Put another way, the three peripheral limits L1, L2 and L3 are mixed in projection onto the reference plane RP, as shown in Figure 5b and 5c with the section plane of Figure 5b superimposed with the interface between the bottom metal layer portion 3b and the bulk portion 3a. Thus, the attachment layer portion 6, the bottom metal layer portion 3b and the bulk portion 3a have respective extension areas parallel to the reference plane RP which are identical and superimposed. In particular, the peripheral limit L3 of the bulk portion 3a exhibits the same acute angles $\alpha$ as the peripheral limit L1 of the attachment layer portion 6 and the peripheral limit L2 of the bottom metal layer portion 3b. For such further embodiment of the invention, the DBC-type intermediate support 3 may be manufactured using a ceramic bulk portion 3a which is initially provided with desired peripheral limit L3 that includes the acute angles $\alpha$ with concave fillets.

In all embodiments of Figures 3a-3c, 4a-4c and 5a-5c, the bulk portion 3a is larger than the top metal layer portion 3c all around this latter parallel to the reference plane RP.

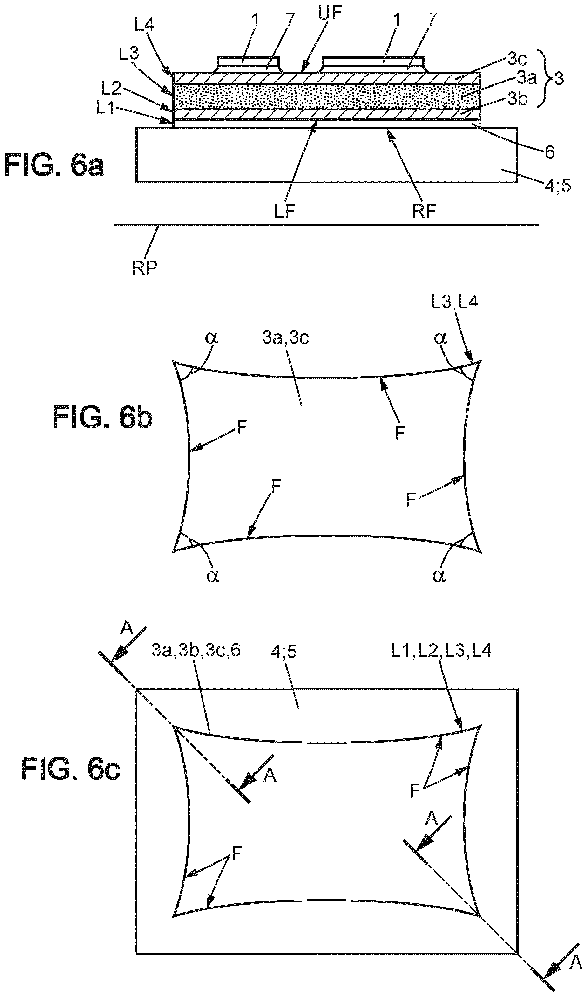

Compared with the embodiment of Figures 5a-5c, the further embodiment of Figures 6a-6c is obtained by modifying the peripheral limit L4 of the top metal layer portion 3c so that it becomes superimposed with the three peripheral limits L1, L2 and L3. Put another way, the four peripheral limits L1-L4 are now mixed in projection onto the reference plane RP, as shown in Figures 6b and 6c with the section plane of Figure 6b superimposed with the interface between the top metal layer portion 3c and the bulk portion 3a. Thus, the attachment layer portion 6, the bottom metal layer portion 3b, the bulk portion 3a and the top metal layer portion 3c have respective extension areas parallel to the reference plane RP which are all identical and superimposed. In particular, the peripheral limit L4 of the top metal layer portion 3c exhibits the same acute angles $\alpha$ as the peripheral limits L1-L3. For such further embodiment of the invention, the DBC-type intermediate support 3 may be manufactured using a top copper layer portion 3c which is initially provided with desired peripheral limit L4 that includes the acute angles $\alpha$ with concave fillets.

Each of the next invention improvements is presented from that of Figures 6a-6c but could be presented from any other one.

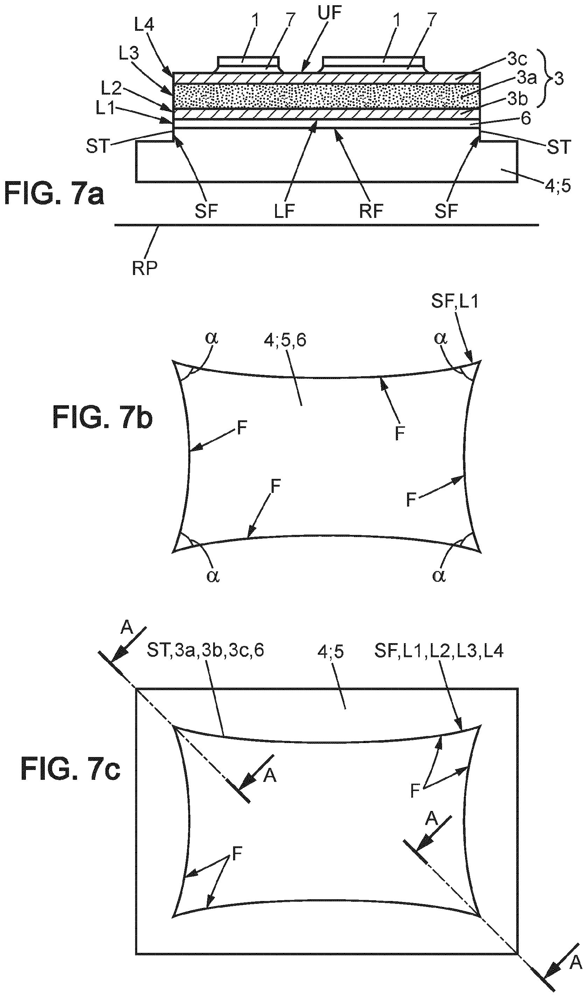

Starting from the embodiment of Figures 6a-6c, the further embodiment of Figures 7a-7c is obtained by shaping the main support 4, 5 in its receiving face RF so as to provide it with a step ST. Such step ST may be produced by appropriate machining of the main support 4, 5 and has a step face SF which is perpendicular to the reference plane RP. For example, the height of the step face SF can be chosen to be close to or higher than the thickness of the attachment layer 6 which is typically about 200 μm (micrometer) when measured perpendicular to the reference plane RP. According to the present invention improvement, the step face SF has same outline as the peripheral limit L1 in projection in the reference plane RP, and is superimposed with the peripheral limit L1 by appropriate positioning of the attachment layer portion 6 on the main support 4, 5. Figure 7b which is drawn in the section plane superimposed with the interface between the main support 4, 5 and the attachment layer portion 6 illustrates such superposition.

The embodiment of Figures 7a-7c may be obtained alternatively by having the main support 4, 5 comprising a base part and an additional layer portion. The base part and the additional layer portion may be both of a same metal, for example copper, and soldered to each other. The base plate has an upper face which is planar and larger than the additional layer portion parallel to the reference plane RP. The additional layer portion then has a peripheral edge face which is perpendicular to the reference plane RP and forms the step face SF once the additional layer portion has been attached to the upper face of the main support 4, 5. The embodiment of Figure 7a-7c can be recovered in this way by providing the peripheral edge face of the additional layer portion with an outline which is identical to the peripheral limit L1.

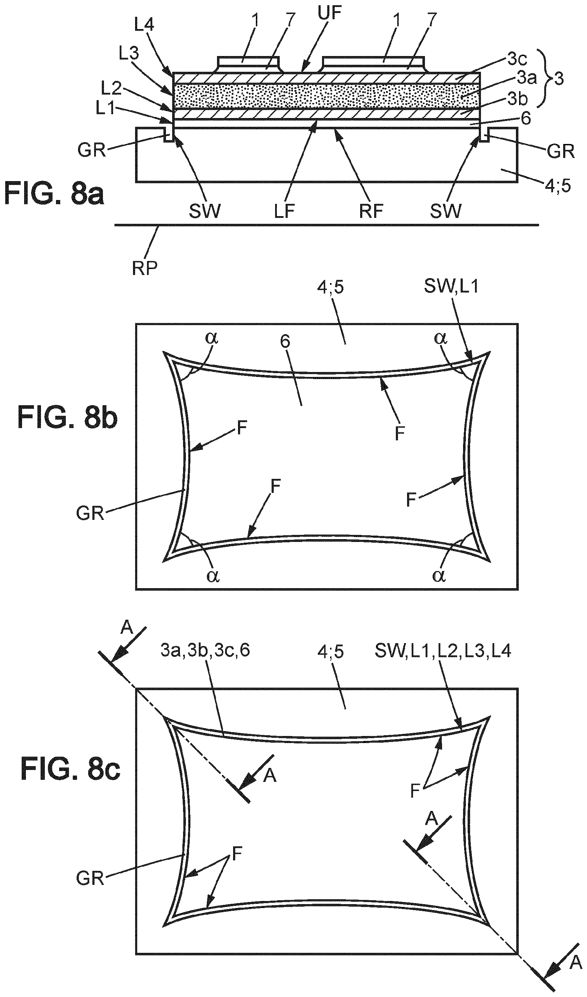

The further embodiment of Figures 8a-8c is obtained from the embodiment of Figures 6a-6c by providing the main support 4, 5 with a groove GR in its receiving face RF. Such groove may be obtained again by appropriate machining of the main support 4, 5. The groove GR has two internal sidewalls which are perpendicular to the reference plane RP and facing each other. According to this invention improvement, one of these groove sidewalls, denoted SW, is superimposed with the peripheral limit L1 of the attachment layer portion 6 and is selected such that the groove GR extends outside the peripheral limit L1. In this way, the attachment layer portion 6 is adhered to the main support 4, 5 throughout the part of the receiving face RF which is limited by the groove sidewall SW. Figure 8b is drawn again in the section plane that is superimposed with the interface between the main support 4, 5 and the attachment layer portion 6, in a same way as Figure 7b.

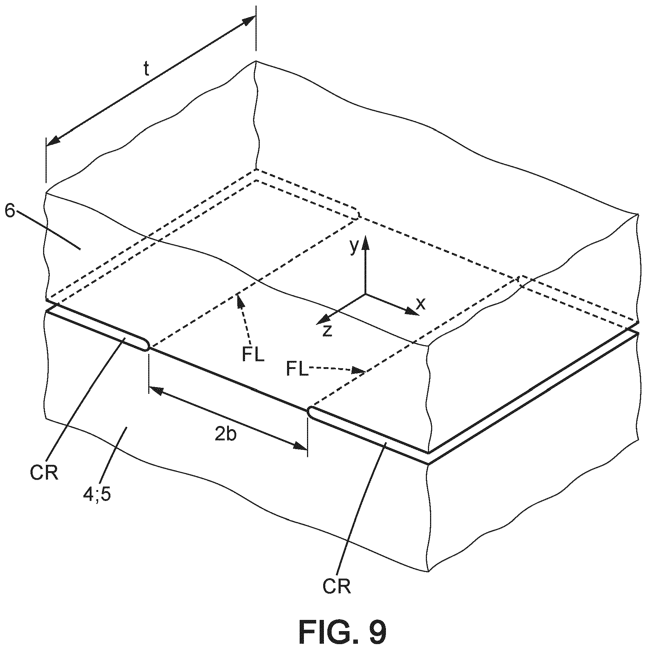

Connection of the invention with known mathematical analysis is now explained with reference to Figure 9. Figure 9 shows the planar interface between the attachment layer portion 6 and the baseplate 4, this latter possibly replaced with the heat dissipation element 5 depending on the module configuration. The interface is parallel to x-z plane, and y-axis is perpendicular to the interface. Let's assume two cracks CR symmetrical with respect to y-z plane and located at the interface. Both cracks CR are separated by a remaining contact length 2b parallel to x-axis and have respective crack front lines FL parallel to z-axis. t is a portion width measured parallel to z-axis. The main driving force for crack progress, i.e. reduction of the remaining contact length 2b over time, is shear due to mismatch between the respective coefficients of thermal expansion of the attachment layer portion 6 and the baseplate 4, combined with a temperature variation $\Delta T$ experienced by both the attachment layer portion 6 and the baseplate 4 at the interface. Then, the driving force for progression of the cracks CR is characterized by the following complex stress intensity factor K:

$$K = \sigma_0(\alpha_4\eta_4 - \alpha_6\eta_6)\Delta T\sqrt{\pi b}(2\varepsilon - i)$$

where i denotes the complex unit, $\varepsilon = \frac{1}{2\pi}\ln\left[\frac{k_6\mu_4+\mu_6}{k_4\mu_6+\mu_4}\right]$ and $\sigma_0 = \frac{4\mu_6\mu_4\cosh(\varepsilon\pi)}{(\mu_6+\mu_4k_6+\mu_6k_4+\mu_4)}$. For large values of t-width, corresponding to wide attachment layer portion 6 or so-called plane strain approximation: $\eta_6 = 1 + v_6$, $\eta_4 = 1 + v_4$ and $k_6 = 3 - 4v_6$, $k_4 = 3 - 4v_4$.

For very small values of t-width, corresponding to narrow attachment layer portion 6 or so-called plane stress approximation: $\eta_6 = \eta_4 = 1$ and $k_6 = \frac{(3-v_6)}{(1+v_6)}$, $k_4 = \frac{(3-v_4)}{(1+v_4)}$.

In these formulae, $\alpha_6$, $v_6$ and $\mu_6$ are respectively the coefficient of thermal expansion, the Poisson's ratio and the shear modulus of the material of the attachment layer portion 6, and $\alpha_4$, $v_4$ and $\mu_4$ are same quantities but for the material of the baseplate 4. Therefore, the modulus of the stress intensity factor K for shear-driven crack progress is reduced for the case of narrow attachment layer portion compared to that of wide attachment layer portion, by a factor equal to $(3 - 4v_0)/(3 - v_0)$ when assuming that $v_4 = v_6 = v_0$. From these analytical considerations, the invention is based on considering that implementing acute $\alpha$-angles for the peripheral limit L1 is closer to the above case of narrow attachment layer portion 6 than the case of wide attachment layer portion 6. Conversely, rounded corners for the peripheral limit L1 are closer to the case of wide attachment layer portion 6.

As a proof of invention efficiency, the inventor simulated cycling four semiconductor modules between -40°C (Celsius degree) and +125°C, with dwell time of 15 minutes each time at -40°C and +125°C, and intermediate temperature ramps of ±15°C/minute. Viscoplastic energy density in the attachment layer portion 6 is used as a damage indicator for estimating respective lifetimes of the four semiconductor modules having identical sizes but with the following features:

- reference semiconductor module: the peripheral limit L1 of the attachment layer portion 6 is rectangular with right angles;

- first test semiconductor module, according to Figures 6a-6c: the peripheral limits L1, L2, L3 and L4 are all identical and superimposed, and comprised of four concave fillets with $\alpha$-angle equalling 60°, and the receiving face RF of the baseplate 4 is flat without step and groove;

- second test semiconductor module, according to Figures 7a-7c: similar to the first test semiconductor module but the receiving face RF of the baseplate 4 is provided with the step ST superimposed with the peripheral limits L1-L4; and

- third test semiconductor module, according to Figures 8a-8c: again similar to the first test semiconductor module but the receiving face RF of the baseplate 4 is provided with a groove GR outside the peripheral limits L1-L4 with the internal groove sidewall SW superimposed with L1-L4.

For all four semiconductor modules, the maximum viscoplastic energy density appears at the tips of the attachment layer portion 6 in its corners. Table 1 below contains these maximum values expressed in MJ/m$^3$ (megajoule per cubic meter):

Table 1

| Semiconductor module | Reference module | First test module | Second test module | Third test module |
|---|---|---|---|---|
| Maximum value (MJ/m$^3$) | 3.30 | 2.94 | 2.13 | 1.80 |
| Lifetime (kcyc) | 24.2 | 32.2 | 63.4 | 80.8 |

The lifetime values expressed in kilocycles and displayed in Table 1 have been calculated using the well-known Coffin-Manson lifetime model, based on a viscoplastic energy density increment which is experienced by the semiconductor modules for each further temperature cycle of the type previously described. Therefore important increases in the semiconductor module lifetime result from the invention and its improvements.

It is repeated that the invention can be implemented whatever the type of the electrical circuit embodied in the die(s) and whatever the type of the main support, this main support possibly being a baseplate, a heat dissipating element or other depending on the configuration of the semiconductor module. In addition, the top metal layer portion of the intermediate support, in particular when of DBC-type but not only, may be divided into several sub-portions which are next to one another on the bulk portion of the intermediate support, but with the outer edges of all sub-portions determining the peripheral limit L4.

**Claims**

1.  A semiconductor module comprising:

    - at least one semiconductor die (1), which incorporates at least one electrical component (T1, T2, D1, D2);
    - an intermediate support (3) having upper and lower faces parallel to a reference plane (RP);
    - a main support (4; 5) having a receiving face (RF) parallel to the reference plane (RP); and
    - an attachment layer portion (6),

    wherein the at least one semiconductor die (1) is attached to the upper face (UF) of the intermediate support (3), and the lower face (LF) of said intermediate support is attached to the receiving face (RF) of the main support (4; 5) through the attachment layer portion (6), said attachment layer portion being attached to the intermediate support throughout the lower face of said intermediate support and attached to the main support throughout a face of said attachment layer portion which is parallel to the reference plane (RP), the attachment layer portion (6) having a peripheral limit, referred to as first peripheral limit (L1), which entirely surrounds the lower face (LF) of the intermediate support (3) in a projection onto the reference plane (RP), **characterized in that** the first peripheral limit (L1) forms acute angles ($\alpha$) parallel to the reference plane (RP).

2.  The semiconductor module of claim 1, wherein all angles ($\alpha$) formed by the first peripheral limit (L1) are less than 90°, preferably less than 80°, more preferably less than 75°.

3.   The semiconductor module of claim 1 or 2, wherein the first peripheral limit (L1) is comprised of several, preferably four, concave fillets (F) connected to one another at the acute angles (α).

4.   The semiconductor module of one of claims 1 to 3, wherein the acute angles (α) are formed by the first peripheral limit (L1) in extension parts of the attachment layer (6) that protrude parallel to the reference plane (RP) beyond the lower face (LF) of the intermediate support (3), preferably beyond corners of said lower face of the intermediate support.

5.   The semiconductor module of one of claims 1 to 3, wherein the intermediate support (3) comprises a bulk portion (3a) and a bottom metal layer portion (3b) which is adhered to the bulk portion and forms the lower face (LF) of said intermediate support, and wherein the bottom metal layer portion has a peripheral limit, referred to as second peripheral limit (L2), parallel to the reference plane (RP) which is superimposed with the first peripheral limit (L1).

6.   The semiconductor module of claim 5, wherein the bulk portion (3a) of the intermediate support (3) has a peripheral limit, referred to as third peripheral limit (L3), which surrounds the second peripheral limit (L2) parallel to the reference plane (RP), with the bulk portion (3a) being larger than the bottom metal layer portion (3b) parallel to the reference plane.

7.   The semiconductor module of claim 5, wherein the bulk portion (3a) of the intermediate support (3) has a peripheral limit, referred to as third peripheral limit (L3), parallel to the reference plane (RP) which is superimposed with the second peripheral limit (L2).

8.   The semiconductor module of one of claims 5 to 7, wherein the intermediate support (3) further comprises at least one top metal layer portion (3c) which is adhered to the bulk portion (3a) opposite the bottom metal layer portion (3b) and which forms the upper face (UF) of said intermediate support, and wherein the at least one top metal layer portion is surrounded by the third peripheral limit (L3) parallel to the reference plane (RP), with the bulk portion being larger than the at least one top metal layer portion parallel to the reference plane.

9.   The semiconductor module of one of claims 5 to 7, wherein the intermediate support (3) further comprises at least one top metal layer portion (3c) which is adhered to the bulk portion (3a) opposite the bottom metal layer portion (3b) and which forms the upper face (UF) of said intermediate support, and wherein the at least one top metal layer portion has a peripheral limit, referred to as fourth peripheral limit (L4), parallel to the reference plane (RP), which is superimposed with the third peripheral limit (L3).

10.  The semiconductor module of one of the claims 1 to 9, wherein the receiving face (RF) of the main support (4; 5) is shaped so as to exhibit a step (ST) that has a step face (SF) perpendicular to the reference plane (RP), and the step face is superimposed with the first peripheral limit (L1) all along said first peripheral limit.

11.  The semiconductor module of one of the claims 1 to 9, wherein the main support (4; 5) comprises a base part and an additional layer portion which is attached to the base part, so that the receiving face (RF) of said main support is formed by the additional layer portion and limited by an edge face of said additional layer portion which is perpendicular to the reference plane (RP) and superimposed with the first peripheral limit (L1) all along said first peripheral limit.

12.  The semiconductor module of one of claims 1 to 9, wherein the receiving face (RF) of the main support (4; 5) is shaped so as to exhibit a groove (GR) that has an internal sidewall (SW) perpendicular to the reference plane (RP), and the internal sidewall of the groove is superimposed with the first peripheral limit (L1), with the groove extending outside said first peripheral limit.

13.  The semiconductor module of one of the preceding claims, wherein the at least one die (1) incorporates at least one electrical component (T1, T2, D1, D2) selected from the list consisting of a diode, a transistor, in particular of isolated-gate bipolar transistor type or of metal-oxide-semiconductor field effect transistor type, and a thyristor.

14.  The semiconductor module of one of the preceding claims, forming a circuit part selected from the list consisting of a rectifier branch, a rectifier, an inverter branch, an inverter, a chopper, a switch-type power source branch and a switch-type power source.

15.  The semiconductor module of one of the preceding claims, comprising several semiconductor dies (1) attached apart from each other to the upper face (UF) of the intermediate support (3), and the semiconductor module further comprises electrical interconnections (2) that connect at least one electrical component (T1, T2, D1, D2) of one of the dies to at least one other electrical component of another one of the dies.

**FIG. 1a**

**FIG. 1b**

FIG. 2

FIG. 3a

FIG. 3b

FIG. 3c

FIG. 4a

FIG. 4b

FIG. 4c

FIG. 5a

FIG. 5b

FIG. 5c

FIG. 6a

FIG. 6b

FIG. 6c

FIG. 7a

FIG. 7b

FIG. 7c

FIG. 8a

FIG. 8b

FIG. 8c

FIG. 9

Europäisches
Patentamt

European
Patent Office

Office européen
des brevets

# EUROPEAN SEARCH REPORT

**Application Number**

EP 24 30 6536

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2016/020161 A1 (SUZUKI KENJI [JP]) 21 January 2016 (2016-01-21) * paragraph [0030] * * figures 1, 8-9 * ----- | 1-15 | INV. H01L23/367 H01L23/13 H01L23/373 H01L23/14 |
| A | US 2022/102227 A1 (CARDI VALERIANO [IT] ET AL) 31 March 2022 (2022-03-31) * figures 1-10 * ----- | 1-15 | H01L23/538 H01L25/07 |
| A | WO 2023/163423 A1 (AMOGREENTECH CO LTD [KR]) 31 August 2023 (2023-08-31) * figures 1-4 * ----- | 1-15 | |

**TECHNICAL FIELDS SEARCHED (IPC)**

H01L

The present search report has been drawn up for all claims

| Place of search | Date of completion of the search | Examiner |
|---|---|---|
| The Hague | 21 February 2025 | Rodríguez San S., H |

EPO FORM 1503 03.82 (P04C01)

## ANNEX TO THE EUROPEAN SEARCH REPORT
## ON EUROPEAN PATENT APPLICATION NO.

EP 24 30 6536

This annex lists the patent family members relating to the patent documents cited in the above-mentioned European search report.
The members are as contained in the European Patent Office EDP file on
The European Patent Office is in no way liable for these particulars which are merely given for the purpose of information.

21-02-2025

| Patent document cited in search report | Publication date | Patent family member(s) | | Publication date |
|---|---|---|---|---|
| US 2016020161 A1 | 21-01-2016 | CN | 105304578 A | 03-02-2016 |
| | | JP | 6398405 B2 | 03-10-2018 |
| | | JP | 2016021508 A | 04-02-2016 |
| | | US | 2016020161 A1 | 21-01-2016 |
| US 2022102227 A1 | 31-03-2022 | CN | 114334892 A | 12-04-2022 |
| | | EP | 3979313 A1 | 06-04-2022 |
| | | US | 2022102227 A1 | 31-03-2022 |
| WO 2023163423 A1 | 31-08-2023 | KR | 20230126340 A | 30-08-2023 |
| | | WO | 2023163423 A1 | 31-08-2023 |

EPO FORM P0459

For more details about this annex : see Official Journal of the European Patent Office, No. 12/82